# EUROPEAN PATENT SPECIFICATION

(11) **EP 0 498 887 B1**
(45) Date of publication and mention of the grant of the patent: **07.12.1994**
(21) Application number: 90915813.1
(22) Date of filing: 25.10.1990
(51) Int. Cl.: C01B 33/035

(54) **CORE WIRE CONNECTING BRIDGE FOR POLYCRYSTALLINE SILICON MANUFACTURING APPARATUSES**
VERBINDUNGSBRÜCKE FÜR KERNDRÄHTE FÜR APPARATE ZUR HERSTELLUNG POLYKRISTALLINEN SILIZIUMS
PONT CONNECTEUR DE CONDUCTEURS CENTRAUX DESTINE AUX APPAREILS DE FABRICATION DE SILICIUM POLYCRISTALLIN

(30) Priority: 04.11.1989 JP 286040/89
(43) Date of publication of application: 19.08.1992
(73) Proprietor: KOMATSU ELECTRONIC METALS CO., LTD, Hiratsuka-shi Kangawa 254 (JP)
(72) Inventor: OHTSUKI, Minoru, Hiratsuka-shi Kanagawa 259-12 (JP); MIYAMOTO, Yusuke, Hiratsuka-shi Kanagawa 259-12 (JP); NAGAI, Kenichi, Tokyo 152 (JP)
(74) Representative: Baverstock, Michael George Douglas
(86) International application number: PCT/JP90/01373
(87) International publication number: WO 91/06507

(56) References cited:
- JP-B- 3 925 899

## Description

This invention relates to a technique for providing polycrystalline silicon which involves less grinding loss and which is used as a material for manufacturing a semiconductor silicon single crystal according to the floating zone process (hereinafter referred to as the FZ process), and more particularly to a bridge for connecting cores which are electrically heated in thermal decomposition equipment.

As technology in the semiconductor field develops there is a demand for semiconductor single crystals which are manufactured according to the FZ process, particularly single silicon crystals, having a larger diameter, and at present even such single crystals which have a 6 inch diameter are manufactured. The diameter of polycrystalline silicon as a rod for obtaining single crystals of such a large diameter is not necessarily the same as that of the single crystal to be obtained because, for example, when using a thin rod, it is possible to enlarge the diameter of the rod by a technique with a stuffing operation. However, the smaller the diameter the longer is the rod required, and a problem in charging the longer rod into the FZ machine arises, so that a blank having a diameter almost the same as that of the single crystal to be obtained is required.

As is described in Japanese Patent Publications Nos. 12358/78 and 23457/80, the polycrystalline silicon to be a rod for manufacturing a silicon single crystal may be obtained in such a way that, for example, a monosilane gas is supplied on to electrically heated filament cores and then thermally decomposed for deposition thereon. If it is intended to obtain polycrystalline silicon which is crushed for use, it is usual for a bridge for electrically connecting filament cores in the manufacturing equipment to use silicon materials described in said publications by using the carbon referred to in Japanese Patent Publication No. 23457/80 even from the viewpoints of preventing the bridge from being contaminated by heterogeneous material and of subsequent processing.

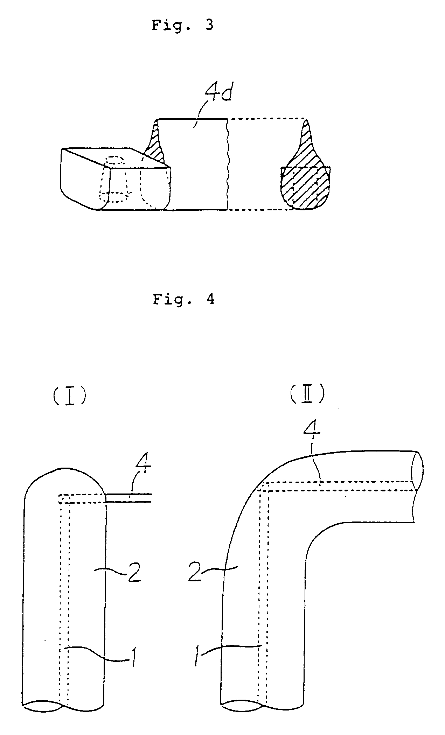

When using silicon materials, polycrystalline silicon deposits on the filament cores and on the connection bridge in the same amount. However, as shown in Fig. 4 (II), as the deposition develops and the connection bridge portion thickens, the gas flow within the thermal decomposition furnace varies, the polycrystalline silicon which deposits on the filament cores is deformed particularly in the neighbourhood of the joints of the connection bridge with the filament cores, when said joints become thinner than other portions and at the same time the initial central axis is moved. A polycrystalline silicon rod used in the FZ process needs to be of uniform diameter, so that when such a rod is used in the FZ process, deposition must be continued until the thin portions increase to a satisfactory diameter, and then the outer diameter of the rod must be ground so as to obtain a predetermined diameter. Naturally, the larger the diameter, the more the grinding loss increases, even in the same grinding ratio, and the more the diameter along a rod changes, the more the grinding loss increases.

Referring to the grinding of the outer diameter, it does not answer the purpose that the outer periphery of the rod becomes uniformly thick, but the rod is ground up to a predetermined diameter so that the resistivity of the intended single crystal may become a predetermined value. Such grinding is employed in any case of embedding or coating of impurities to the outer surface of a polycrystalline rod, doping by gaseous impurities, and control between the resistivity of the filament cores and the resistivity to a finished product whose diameter has increased to as desired.

For these reasons it is specifically necessary for polycrystalline silicon used in the FZ process that the crystals are of uniform diameter from their manufacturing state in order to obtain shortening of growth time, reduction of material or electric charges, reduction of processing steps, reduction of grinding loss, and the like.

However, sufficient measures for solving such problems have not so far been taken.

The present invention has been accomplished to solve the known problems, and it is characterized in that in the equipment of depositing polycrystalline silicon on the filament cores made of electrically heated cores, by means of thermal decomposition of monosilane gas, the bridge for connecting said filament cores is made of molybdenum, tungsten or zirconium and the sectional shape of the connecting bridge is that of an upturned triangle, a tear droplet or a rectangle.

In the drawings:
Fig. 1 is a vertical sectional view of one embodiment of a furnace for manufacturing polycrystalline silicon, which employs a connection bridge according to the invention;
Fig. 2 and Fig. 3, respectively, show the shapes of connection bridges employed in the invention; and
Fig. 4 shows the shape of the polycrystalline silicon deposited near the connection portion of the connection bridge with a filament core.

The connection bridge according to the invention is made of low electrically-resistant molybdenum, tungsten or zirconium, so that even if a bridge of, for example, 7.5 mm diameter as in the known process is used, it is not heated to the decomposition temperature of monosilane gas by electric current. Since monosilane gas is not thermally decomposed on the connection bridge, therefore, polycrystalline silicon is not deposited. That is, since the diameter of the connection bridge does not increase with time, reverse affection such as staying is not given to the flow of gas in the manufacturing furnace, and the intended polycrystalline silicon deposits at a uniform diameter on the filament cores only.

Further, it is found from experiments that molybdenum, tungsten or zirconium hardly react with silicon at the thermal decomposition temperature (750^{o} - 950^{o}C) when preparing polycrystalline silicon by using monosilane; that each of said metals has a low vapour pressure, is slow to diffuse into silicon, and does not adversely affect the characteristics of silicon.

Though Japanese Patent Publication No. 25899/64 discloses an example where a tantalum wire is used for the bridge it does not describe in any way the re-use of the tantalum wire as a bridge for mass production. According to the experiments, tantalum hardly reacts with silicon, and it is the same as molybdenum, tungsten and zirconium except for the influence of hydrogen brittleness, to the extent that it is a chemically stable metal. However, since the bridge of the invention is used within equipment of manufacturing polycrystalline silicon by the process of thermal decomposition of monosilane gas, the atmosphere is more than 95% hydrogen gas, which has been generated by the decomposition of the monosilane gas. Compared with molybdenum, tungsten or zirconium it is likely that the portion where the temperature is particularly high in the bridge portion, i.e. the neighbourhood of the connection of the bridge to the filament cores causes a hydrogen brittleness in tantalum by the hydrogen gas. If the connection portion of the bridge with the filament cores is thickened, the bridge can be recyclically used, but in practice even such a bridge can be used only twice or three times. It is known from experiments that compared with bridges made of molybdenum, which can be used some ten times, those made of tantalum are greatly inferior. Thus, tantalum is not suitable for bridges for mass production. On the other hand, if the connection portion is thickened, the bridge becomes heavy and there occur such problems as frequent breaking of the filament cores and disturbance of the flow of gas within the furnace.

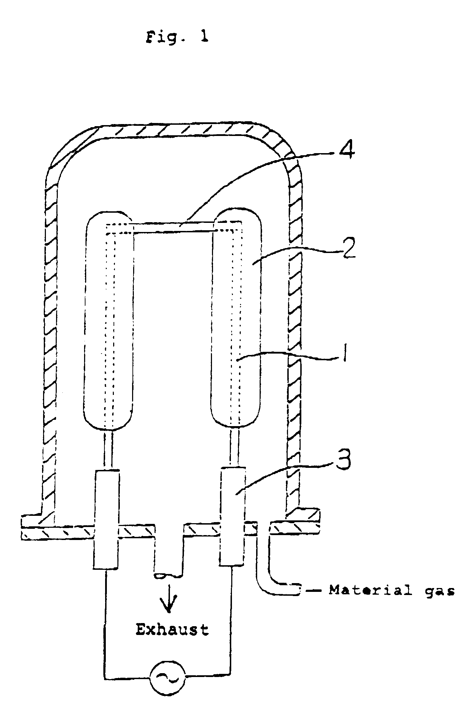

It has been stated above that the sectional shape of the connection bridge is that of an upturned triangle, tear droplet or rectangle. Adoption of such shapes has the purpose of preventing turbulence which generates when the uprising stream in the furnace traverses the connection bridge, as shown in Fig. 1. Additionally, adoption of such shapes increases surface area as compared with a round shape, thereby increasing the amount of heat radiation so as to allow the temperature to be further lowered. Lowering of temperature means possible use of a thinner bridge, and decrease in the turbulence of gas flow caused depending on the shape of bridge. Additionally, it results in decreasing the hindrance to the uprising gas stream, which might be caused by making the bridge narrow, to lower the temperature whereby the effect increases. Naturally, when the polycrystalline silicon rod manufactured for specific use is slender, a slender, round-shaped bridge will suffice. However, it has been the tendency in recent years that it is desired year-by-year to enlarge the diameter of polycrystalline silicon rods. This proves the usefulness of the present invention.

### Example 1

Fig. 1 shows a vertical sectional view of a furnace for manufacturing polycrystalline silicon according to a process of thermal decomposition of monosilane gas, which furnace is equipped with a connection bridge in accord with the present invention.

In the drawings, reference numeral 1 designates silicon filament cores on which silicon polycrystalline deposits, reference 2 polycrystalline silicon deposited on the filament cores, reference 3 electrodes for electrically heating the filament cotes 1, and reference 4 a bridge for connecting the filament cores 1 respectively. For the connection bridge between the filament cores a 7 mm diameter molybdenum rod is used.

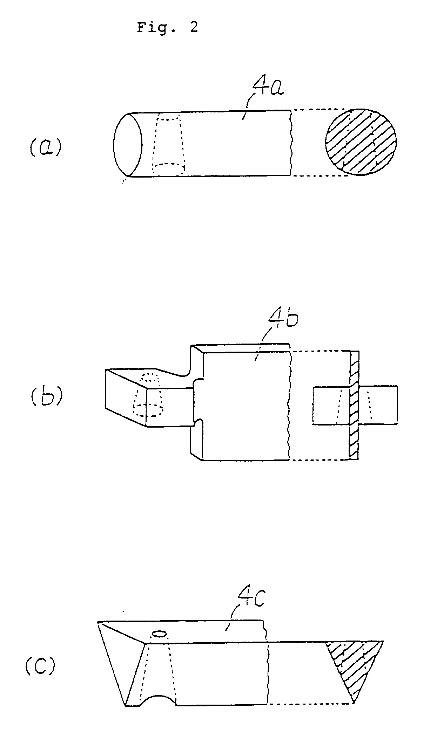

By using the furnace shown in Fig. 1 and a 7 mm diameter molybdenum rod shown in Fig. 2(a) for the connection bridge 4 between the filament cores, monosilane gas was supplied as material gas and the filament cores 1 were electrically heated while depositing polycrystalline silicon 2 by means of the thermal decomposition process. The amount of the monosilane gas supplied was set so that the deposition rate could be 4 - 8 µ/min whereby polycrystalline silicon 2 having a representative 73 mm diameter was obtained. Even after the end of the thermal decomposition, as shown in Fig. 4 (I), deposition of polycrystalline silicon was not observed on the molybdenum connection bridge 4. Such a connection bridge made of molybdenum was re-usable and could be continuously used about 30 times.

Table 1 shows a comparison between the results of this Example and the prior art using silicon for the connection bridge.

Further, according to this Example, molybdenum was used for the connection bridge, and an atomic absorption spectroscopy analysis was carried out on the polycrystalline silicon thus obtained. As a result, it was found that molybdenum within 0.1 ppma concentration was detected in the polycrystalline silicon rods within a distance of 2 mm from the contact portions with the connection bridge 4 but not in other portions. Furthermore, single crystal silicon was prepared, according to the FZ process, based on polycrystalline silicon as material, and no particular problem occurred.

**Table 1**

| | This Example | Known apparatus |
|---|---|---|
| Diameter of connection bridge | 7 mm | |
| Length of filament core | 2000 mm | |
| Target diameter of end product | 73 mm | |
| Diameter of product | 74 ± 0.8 mm | |
| Length of product | 1900 mm | 1800 mm |
| Power consumption | 70% | 100% |
| Amount of material gas consumption | 85% | 100% |
| Operation time | 85% | 100% |

### Example 2

7 mm diameter tungsten was adopted for the connection bridge 4, and in the same manner as in Example 1 polycrystalline silicon was manufactured by the process of thermal decomposition of monosilane gas. The result obtained was the same as in Example 1.

### Example 3

A molybdenum plate having a 2 x 19 mm section as shown in Fig. 2(b) was adopted for the connection bridge 4, and in the same manner was in Example 1 polycrystalline silicon was prepared by the process of thermal decomposition of monosilane gas. The result obtained was the same as in Example 1.

### Example 4

An upturned triangle-shaped molybdenum plate of 7 mm base x 10 mm height as shown in Fig. 2(c) was adopted for the connection bridge 4, and in the same manner as in Example 1 polycrystalline silicon was prepared by the process of thermal decomposition of monosilane gas. The result thus obtained was the same as in Example 1.

### Example 5

A molybdenum plate having a tear droplet-like section as shown in Fig. 3 was adopted for the connection bridge 4, and in the same manner was in Example 1 polycrystalline silicon was manufactured by the process of thermal decomposition of monosilane gas. The result was such that up to about 70 mm diameter of the product it was the same as in Example 1, but for the products having a diameter greater than 70 mm there could be obtained products slightly longer (+ 30 mm - + 40 mm) than those when using a bridge of round-shaped section.

As a result of using low resistant molybdenum, tungsten or Zirconium the connection bridge of the present invention generates less heat, so that even after the lapse of time until the polycrystalline silicon depositing on a filament cores grows to a predetermined diameter, the polycrystalline silicon does not deposit on the connection bridge. Therefore, the flow of the material gas in the furnace does not vary from the initial growing stage to the final stage, and turbulence is not caused by temperature rise or increase of diameter. When the uprising stream of the material gas near the rods is always stable, it results in the deposition of the polycrystalline silicon being rate-determined only by the speed of movement of the material gas which moves onto the filament cores, and it is already known that the uniformity of the diameter is good. Furthermore, the flow of the material gas is not disturbed if a connection bridge of the present invention is employed, so that it is possible to obtain polycrystalline silicon having better uniform diameter.

Moreover, in using a connection bridge having a sectional shape such as upturned triangle, tear droplet or rectangle the flow of the material gas is hardly disturbed, but particularly the bridge of tear droplet shape in section produces a superior effect thereby obtaining a polycrystalline silicon of excellent uniform diameter.

Additionally, since silicon does not deposit on the connection bridge less of the material gas is consumed and variation of the material gas concentration hardly occurs, and since the bridge is scarcely affected by hydrogen brittleness the bridge can be recyclically used many times.

For these reasons, the polycrystalline silicon thus obtained does not become thinner in its diameter in the neighbourhood of the connection bridge and does not become eccentric. The length of the product is longer than that of known products, the power and material gas needed for manufacturing the polycrystalline silicon rods as well as loss in processing are saved, and even the grinding time is curtailed whereby productivity is improved.

Additionally, if silicon is used for the connection bridge as in the conventional process, it is difficult to cut off the bridge. However, since the metallic materials employed in the connection bridge of the present invention differ from silicon in coefficient of thermal expansion the bridge can be easily cut off.

Since the bridge can be recyclically used many times the present invention contributes to resource saving and improved economy.

## Claims

1. A bridge for connecting filament cores in a manufacturing equipment of polycrystalline silicon characterised in that in preparing filament cores which are to be electrically heated in a furnace for manufacturing polycrystalline silicon according to a process of thermal decomposition of a monosilane gas on the surface of which polycrystalline silicon is to be deposited from the vapour phase, said bridge for connecting the filament cores is constituted by molybdenum, tungsten or zirconium, and the sectional shape of said connecting bridge is that of an upturned triangle, a tear droplet or a rectangle.

## Patentansprüche

1. Brücke zum Verbinden von Kerndrähten in einer Ausrüstung zur Herstellung von polykristallinem Silicium, dadurch gekennzeichnet, daß beim Herrichten von elektrisch in einem Ofen zu beheizenden Kerndrähten zur Herstellung von polykristallinem Silicium nach einem Verfahren zur thermischen Zersetzung eines Monosilangases, auf deren Oberfläche polykristallines Silicium aus der Dampfphase abzuscheiden ist, die Brücke zum Verbinden der Kerndrähte aus Molybdän, Wolfram oder Zirconium besteht und die Querschnittform der Verbindungsbrücke die eines umgedrehten Dreiecks, eines Tropfens oder eines Rechtecks ist.

## Revendications

1. Pont de connexion de filaments centraux dans un équipement de fabrication de silicium polycristallin, caractérisé en ce que, pour la préparation de filaments centraux, qui doivent être chauffés de manière électrique dans un four de fabrication de silicium polycristallin selon un procédé de thermolyse d'un gaz monosilane, sur la surface desquels du silicium polycristallin doit être déposé à partir de la phase vapeur, ledit pont de connexion des filaments centraux est fait de molybdène, de tungstène ou de zirconium, et la forme de section dudit pont de connexion est celle d'un triangle renversé, d'une goutte d'eau ou d'un rectangle.
